# EUROPEAN PATENT APPLICATION

(11) **EP 1 022 628 A1**
(43) Date of publication of application: **26.07.2000**
(21) Application number: 00300259.9
(22) Date of filing: 14.01.2000
(51) Int. Cl.: G05B 19/05, G05B 19/045, G05B 19/048

(54) **Read-only sequence controller having a gate array composition**

(30) Priority: 21.01.1999 JP 5129499; 18.05.1999 JP 17309599
(71) Applicant: Kuze, Yoshikazu, Tokyo (JP)
(72) Inventor: Kuze, Yoshikazu, Ohta-ku, Tokyo (JP)
(74) Representative: Rees, Alexander Ellison

(57) **Abstract**

A master circuit and a slave circuit are provided. The master circuit has a first presettable counter for setting a first cycle, and a clock pulse generating circuit for producing an instruction pulse at the first cycle determined by the first presettable counter, the slave circuit has a second presettable counter for setting a second cycle, and a pulse generating circuit for producing a plurality of pulses at the second cycle in response to the instruction pulse from the master circuit. There is provided a gate array comprising a plurality of gates and formed into an integrated circuit having a plurality of pins, and provided for relaying signals among signals from the master circuit and slave circuit. A transistor array is connected to an input for decreasing an input impedance of the controller.

## Description

### BACKGROUND OF THE INVENTION

The present invention relates to a compact read-only sequence controller.

In order to reduce the consumption current to save energy, such a device as a CMOS-IC is generally used in the sequence controller. If an external signal line is directly connected to the CMOS-IC, the CMOS-IC may break down due to noises. In order to prevent the CMOS-IC from breaking down, the CMOS-IC is connected to the external signal line through a chatter killer array.

However, since the input impedance of the CMOS-IC is high, if only the chatter killer array is connected, the input noises cannot be completely removed, which causes the sequence controller to be erroneously operated.

### SUMMARY OF THE INVENTION

An object of the present invention is to provide a sequence controller, of which the input impedance is decreased so as to improve the resistance to noises.

To this end, a transistor array is accordingly connected before the chatter killer array.

In the system of the present invention, a master circuit A and a slave circuit B have a master-slave relationship. The command one pulse generated from the master circuit A at every 2.5 seconds is applied to the slave circuit B to start a processing machine such as presses which consequently performs an operation in one cycle in the predetermined 1.5 seconds and then stops. When a sensor disposed at an outlet of the machine generates a signal indicating that a machined work has passed, the machine is restarted in accordance with the next command pulse from the master circuit A. The machine is thus continuously operated provided there does not occur any abnormality. However if there is an abnormality, the sensor does not generate the signal indicating the passage of the work although the slave circuit has completed the one cycle operation. An abnormality signal is produced based on the command pulse generated from the master circuit A for the next cycle, and the machine stops. After the abnormal portion is checked and repaired, a reset switch is turned on, and thereafter, a start switch is turned on. Hence the machine resumes the operation.

These and other objects and features of the present invention will become more apparent from the following detailed description with reference to the accompanying drawings.

### BRIEF DESCRIPTION OF DRAWINGS

Fig. 1 is a plan view of a read-only sequence controller according to the present invention;
Fig. 2 shows a clock pulse control unit housed in the controller of Fig. 1;

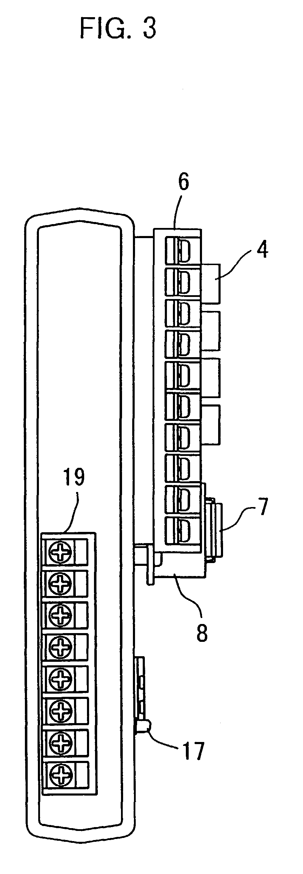

Fig. 3 is a side view of the controller of Fig. 1;
Fig. 4 shows a circuitry of the sequence controller of the present invention;
Fig. 5 is a full-scale diagram showing a wiring pattern of the control unit of the controller;
Fig. 6 shows a circuit of a conventional control unit which is granted a patent in the US to the applicant of the present invention; and
Fig. 7 shows the circuit of Fig. 6, a part surrounded by a bold line of which is included in a gate array having forty pins provided in the controller of the present invention.

### DETAILED DESCRIPTION OF THE PREFERRED EMBODIMENTS

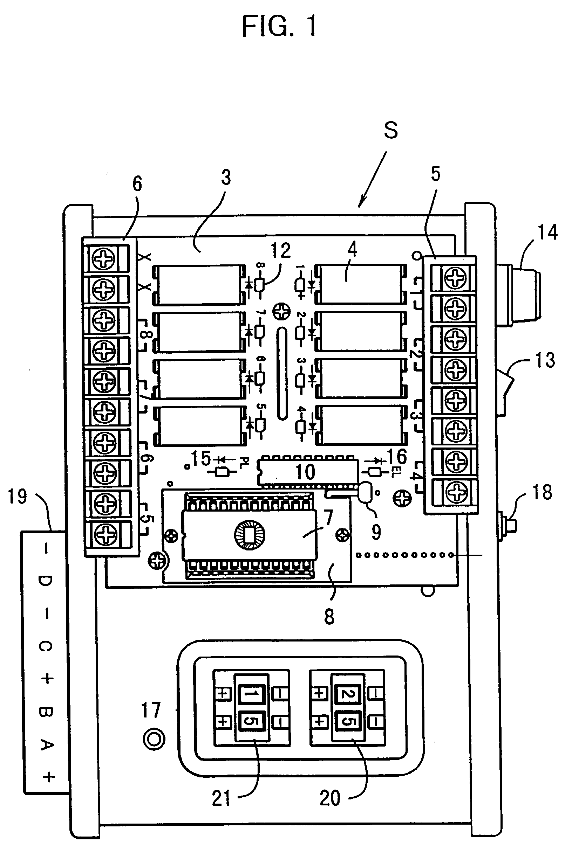

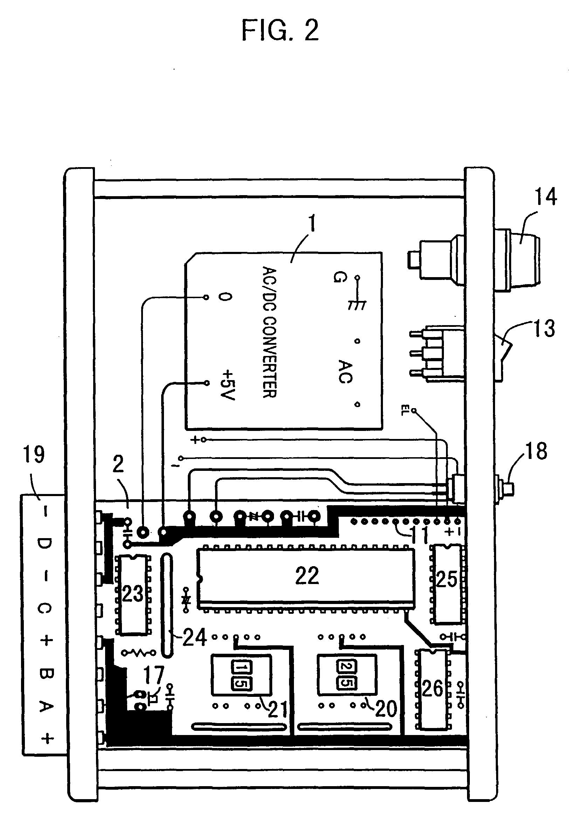

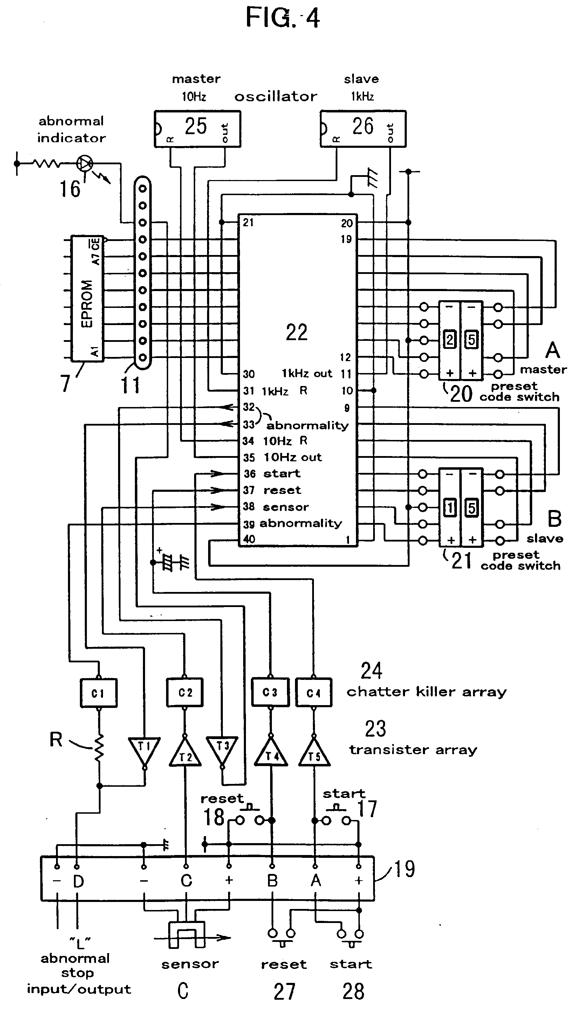

Referring to Fig. 1, a read-only sequence controller S of the present invention is divided into a master circuit A and a slave circuit B (Fig. 4). The sequence controller S comprises a read clock pulse control unit 2 which is shown in Fig. 2, and which is housed in the sequence controller and connected to an AC/DC converter 1 for DC 5V, and an output relay unit 3. The output relay unit 3 comprises a printed circuit board. Eight relays 4 for eight output terminals, and terminal units 5 and 6 are mounted on the output relay unit 3. The terminal unit 5 has eight terminals for four relays, because of two poles of each relay, and the terminal unit 6 has ten terminals for the other four relays and for an alternating current power supply X, Y. An EPROM 7 in which program data for the processing machine are written beforehand, is detachably fixed to a connector 8 by a lock lever 9.

The sequence controller S further comprises a transistor array 10 for operating the relays 4, and a ribbon connector 11 provided for connecting the clock pulse control unit 2 and the output relay unit 3. Eight LEDs 12 are provided for displaying the operation of the eight relays. There are provided with a power switch 13, fuse 14, a power LED 15 which is lighted when the power switch 13 is turned on, an abnormality LED 16 which is lighted when an abnormality occurs, start switch 17, reset switch 18, input terminals 19, a preset code switch 20 for the master circuit A, and a preset code switch 21 for the slave circuit B.

The preset code switch 20 displays a two-digit number for one cycle time and is adapted to select a necessary cycle time. In the present embodiment, one cycle time is 0.1 second and the number of "25" is set at the preset code switch 20. The number of 25 signifies a cycle time of 2.5 seconds. Similarly, the preset code switch 21 displays the number of "15" which signifies a cycle time of 1.5 seconds. Although the cycle time of the slave circuit is generally set at 1.5 seconds, with consideration to the longevity of the machine and die, since there is still a room in the cycle time of the master circuit, it is advantageous to increase the cycle time to 4.0 seconds.

Fig. 4 shows a circuit constructed around a gate array 22 having 40 pins. The gate array 22 is made into a CMOS-IC, and comprises a plurality of gates for processing input signals and controlling external devices such as relays 4.

In Fig. 4, the pins 2 through 9 of the gate array 22 are connected to the preset code switch 21 of the slave circuit B, the pins 12 to 19 to the preset code switch 20 of the master circuit A, pins 22 to 29 to the EPROM 7 through the ribbon connector 11. A clock out of a clock pulse generating circuit 25 of the master circuit A is connected to a pin 35 of the gate array, while a reset terminal R is connected to a pin 34. A clock out of a clock pulse generating circuit 26 of the slave circuit B is connected to a pin 11, while a reset terminal R is connected to a pin 31. The thirty-four pins of the gate array 22, excluding six pins for positive and negative terminals of the power source, are connected one to one to respective external functional parts through parallel printed wiring at minimum distances.

In accordance with the present invention, a transistor array 23 is disposed before a chatter killer array 24 which is disposed before the gate array 22. Thus, the input impedance of the gate array 22 is decreased.

In operation, the clock pulse generating circuit 25 of the master circuit A produces an instruction pulse. The instruction pulse is applied to the clock pulse generating circuit 26 of the slave circuit B to start the one cycle operation.

When a command one pulse generated at the master circuit is applied to the slave circuit, the slave circuit operates the relays 4 for operating a processing machine in accordance with the program stored in the EPROM 7. Accordingly the machine performs an operation of one cycle in accordance with the program stored in the EPROM 7. When the operation of one cycle is completed, the machine is stopped by a signal from the slave circuit B. When a sensor C disposed at an outlet of the machine detects the passage of a machined work, a signal from the sensor C is fed to a terminal of the input terminal 19, and the signal is applied to a pin 38 through a transistor T2 of the transistor array 23 and a chatter killer circuit C2 of the chatter killer array 24. The machine is restarted after the next command one pulse from the master circuit is applied.

If there is an abnormality so that the sensor C does not generate the signal although the slave circuit completes the one cycle, abnormality signals are simultaneously generated at pins 32 and 33 of the gate array 22. Namely, the abnormality signal from the pin 32 of the gate array 22 of Fig. 4 is applied to the abnormality indicating LED 16 through a transistor T3 of the transistor array 23 and the ribbon connector 11 to light the LED 16. At the same time, the signal from the pin 33 is applied to an abnormality stop pin 39 through a transistor T1 of the transistor array 23, resistor R, and a chatter killer circuit C1 of the chatter killer array 24, so that the clock pulse generating circuit 26 stops generating the pulse, thereby stopping the operation of the machine due to the abnormality.

After the abnormality is checked and repaired, the reset switch 18 is pressed. Hence a reset signal is applied to a pin 37 of the gate array 22 through a transistor T4 of the transistor array 23 and a chatter killer circuit C3 of the chatter killer array 24. Thereafter, the start switch 17 is pressed. A start signal is hence applied to a pin 36 of the gate array 22 through a transistor T5 of the transistor array 23 and a chatter killer circuit C4 of the chatter killer array 24 to start the machine.

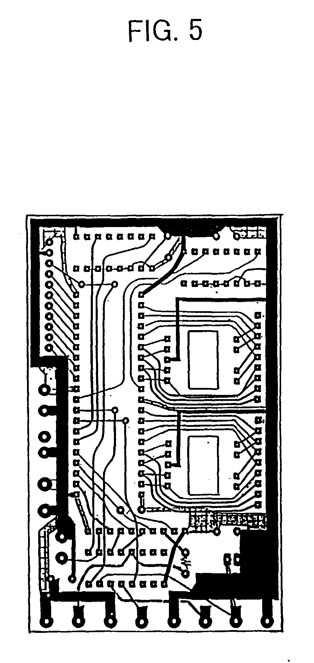

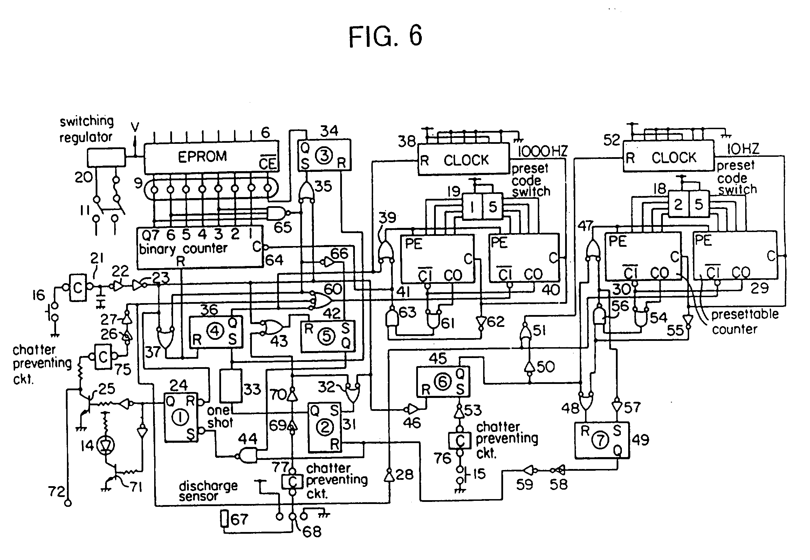

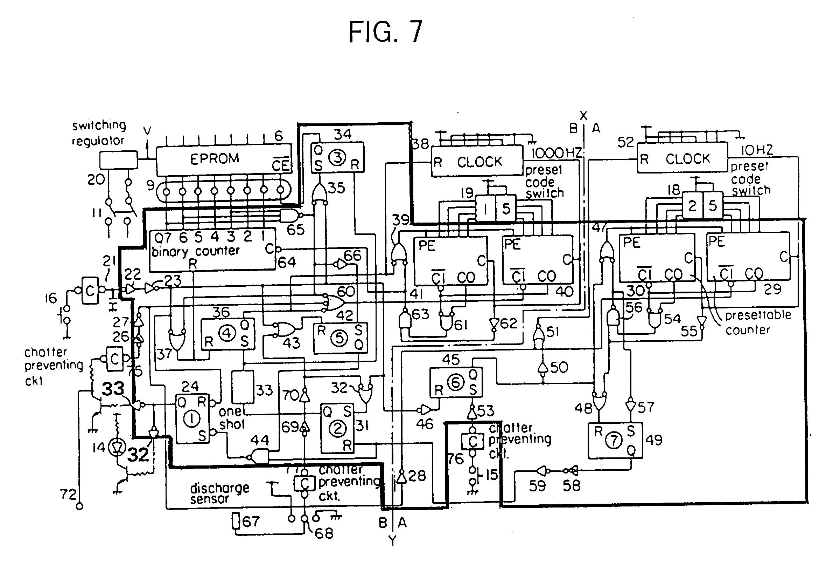

Fig. 5 is a full-scale diagram of the wiring pattern according to the present invention, and Fig. 6 shows a circuit of a conventional sequence controller, a patent application of which has been filed by and granted to the applicant in the United States (Patent No. 5,357,422). A portion enclosed by a bold line in Fig. 7, is entirely included in the gate array 22 having forty pins. In Fig. 7 the right side of the dot dash line X-Y is the master circuit A and the left side is the slave circuit B. The numerals 31, 32, 33, 34, 35 of Fig. 7 indicate the positions of corresponding pins of Fig. 4. If an abnormality occurs in the machine so that there is no signal from a sensor 67 of the system of Fig. 7 which is provided at the outlet of the machine, although the slave circuit finished one cycle, a flip-flop ① is set. The output Q of the flip-flop ① is divided into two, so that the pin 32 and the pin 33 of the gate array 22 (which are also described in Fig. 7) simultaneously generate the abnormal signals. In addition, a reset switch 27, start switch 28 and abnormality stop input/output terminal D of Fig. 4 may be connected through the input terminals 19 so as to remote-control the sequence controller.

In accordance with the present invention, all of complicated electronic circuits are integrated as a single gate array, and the connections between the gate array and the external functional parts are realized needing a small number of printed wires of minimum length so that short circuit between the parts and error in wiring are prevented, and the circuit is resistive to vibration. Moreover, the transistor array is provided for decreasing the input impedance of chatter killer array, thereby preventing erroneous operation. Although the controller is compact weighing about 420 grams, when attached to a cold forging press of 160 tons, a complete unmanned progressive three-process operation can be carried out every day without failure. A single sensor provided at the outlet of the machine checks the existence of the abnormality at every cycle. When there is no abnormality, the consecutive operation is continued. When an abnormality is detected, the press is adapted to stop at the top dead point. The present invention is effective as a labor-saving means not only in the unmanned press machine, but also in automations of various machines, assembly machines, testing machines. The effect of the present invention is tremendous.

While the invention has been described in conjunction with preferred specific embodiment thereof, it will be understood that this description is intended to illustrate and not limit the scope of the invention, which is defined by the following claims.

## Claims

1. A read-only sequence controller for controlling operation of a machine, comprising:
a master circuit having a first presettable counter for setting a first cycle, and a clock pulse generating circuit for producing an instruction pulse at the first cycle determined by the first presettable counter;
a slave circuit having a second presettable counter for setting a second cycle, and a pulse generating circuit for producing a plurality of pulses at the second cycle in response to the instruction pulse from the master circuit;
an EPROM storing a machine operating program data and for producing a program data in response to the pulses fed from the slave circuit;
an output relay unit operated in accordance with the program data fed from the EPROM;
a gate array comprising a plurality of gates and formed into an integrated circuit having a plurality of pins, and provided for relaying signals among the master circuit, slave circuit, and EPROM;
an input terminal for receiving outside signals;
a transistor array connected to the input for decreasing an input impedance;
a chatter killer array connected to the transistor array and connected to the transistor array and connected pins of the gate array for supplying input signals.

2. 1 further comprising a sensor provided at an output of the machine so as to detect the passing of a product work to produce an abnormality signal when the product work does not pass the sensor, means for stopping the operation of the pulse generating circuit of the slave circuit, thereby stopping operation of the machine.
